Europäisches Patentamt

European Patent Office

Office européen des brevets

(11) Publication number: **0 266 004 B1**

# EUROPEAN PATENT SPECIFICATION

(45) Date of publication of patent specification: **12.01.94**   (51) Int. Cl.5: **H03H  17/02**, H03H 17/06

(21) Application number: **87202045.8**

(22) Date of filing: **26.10.87**

(54) **Architecture for power of two coefficient fir filter.**

(30) Priority: **27.10.86 US 923534**
**18.12.86 US 944295**

(43) Date of publication of application:
**04.05.88 Bulletin  88/18**

(45) Publication of the grant of the patent:
**12.01.94 Bulletin  94/02**

(84) Designated Contracting States:
**DE FR GB IT**

(56) References cited:
**DE-A- 3 230 030**

**FERNSEH-UND KINO TECHNIK, vol. 39, no. 1,
January 1985, pages 15-19, Heidelberg, DE;
P. DRAHEIM: "Digitale Filter für die Videosig-
nalverarbeitung in Gate-Array-Technik"**

**1974 INTERNATIONAL CONFERENCE ON
COMMUNICATIONS, Minneapolis, Minnesota,
17th - 19th June 1974, pages 18D-1/4, IEEE,
New York, US; A. TOMOZAWA: "Nonrecur-
sive digital filters with coefficients of pow-
ers of two"**

(73) Proprietor: **N.V. Philips' Gloeilampenfabrieken
Groenewoudseweg 1**

**NL-5621 BA Eindhoven(NL)**

(72) Inventor: **Miron, Amihai**
**c/o INT. OCTROOIBUREAU B.V.**
**Prof. Holstlaan 6**
**NL-5656 AA Eindhoven(NL)**
Inventor: **Koo, David**
**c/o INT. OCTROOIBUREAU B.V.**
**Prof. Holstlaan 6**
**NL-5656 AA Eindhoven(NL)**
Inventor: **Bhattacharya, Arup Kumar**
**c/o INT. OCTROOIBUREAU B.V.**
**Prof. Holstlaan 6**
**NL-5656 AA Eindhoven(NL)**
Inventor: **Christofalo, Michael Gabriel**
**c/o INT. OCTROOIBUREAU B.V.**
**Prof. Holstlaan 6**
**NL-5656 AA Eindhoven(NL)**
Inventor: **Shah, Imran Ali**
**c/o INT. OCTROOIBUREAU B.V.**
**Prof. Holstlaan 6**
**NL-5656 AA Eindhoven(NL)**

(74) Representative: **Kooiman, Josephus Johannes
Antonius et al**
**INTERNATIONAAL OCTROOIBUREAU B.V.**
**Prof. Holstlaan 6**
**NL-5656 AA Eindhoven (NL)**

**Description**

BACKGROUND OF THE INVENTION

Field of the invention

This invention pertains to the field of non-recursive digital filters used for digital signal processing and real time digital video processing. In particular it pertains to an architectural realization, in the form of very large scale integrated (VLSI) circuits, of finite impulse response (FIR) filters which do not require multipliers and which have only coefficients of two to the Nth power.

Description of the Prior Art.

Among the different types of digital filters there has been a great deal of interest in finite impulse response (FIR) digital filters (also called transversal filters). The reason for this is that powerful and mature optimization theories exist to aid in the filter design. FIR filters can easily be designed to approximate a prescribed magnitude/frequency response to arbitrary accuracy with an exactly linear phase characteristic. The nonrecursive FIR filters contain only zeroes in the finite z-plane and hence are always stable. These features make them very attractive for most digital signal processing applications.

Finite impulse response (FIR) digital filters are widely used in digital signal processing, as well as in real-time digital video processing. The conventional hardware realization of an FIR digital filter utilizes the basic functional components of delay units, multipliers and adders. Among these basic functional components, multipliers are generally the most complex for hardware realization, and occupy large "real estate" area, which factors increase the cost of the filter. The cost of multipliers in discrete component systems is high. From the point of view of VLSI chip design, the area occupied by a multiplier on an IC filter chip is too large. Cost is not the only important factor; the operational speed of a filter is even more significant in a variety of applications; for example, in real-time video processing and other high speed digital signal processing. In the conventional FIR digital filter, a high percentage of the propagation delay time is due to multipliers, which reduce the speed of the filter. Therefore, to improve the operattional speed, reduce the cost and simplify the structural complexity for VLSI chip design, it is desirable to eliminate time-consuming multipliers from digital FIR filters.

Current technical literature includes numerous articles directed toward the reduction or elimination of multipliers in the architecture or design of FIR digital filters, while at the same time proposing solutions directed to increasing the speed of these filters for use in real time digital signal processing applications.

In the prior patent art, U.S. Patent No. 3,979,701 discloses a non-recursive digital filter composed of a cascaded plurality of basic sections, each of which is characterized by coefficient values of integer powers of two's. The filter of this patent uses no multipliers and claims an operating speed several times faster than other filters which utilize multipliers.

The multiplierless FIR filter disclosed in this application has certain concepts which appear to be similar to those of U.S. Patent No. 3,979,701 but there are important differences.

The filter described in U.S. Patent No. 3,979,701 has two basic building blocks from which the filter is constructed: Type 1 and Type 2. The Type 1 unit has only coefficients with a value of 1 (see line 53 to line 56 of column 3 of U.S. Patent No. 3,979,701); the Type 2 unit has only an even number of delay elements and only three coefficients, the center coefficient value of which is always equal to 1 (see line 7 to line 12 of column 4 of U.S. Patent No. 3,979,701). An equivalent disclosure can be found in the paper "Nonrecursive digital filters with coefficients of powers of two", author A.Tomozawa, presented at the 1974 International Conference on Communications, Minneapolis, Minnesota.

Summary of the invention

The invention pertains to the architecture and VLSI implementation of an FIR digital filter which contains no multipliers and in which the coefficient space is limited to only powers of two. In conventional digital filter design, the filter coefficients are linearly quantized to two to the Nth power different levels. In multiplier-free digital filter design, the filter coefficients are non-linearly quantized to N different levels, each one of which represents a number equal to two to the Nth power. Multipliers may be replaced by shift registers and/or multiplexers in this non- conventional design.

The FIR filter architecture of the present invention uses a structure that is regular and modular. It utilizes for each tap a structure in which three buses go into each tap, the data bus, the coefficient bus and

2

the sum-in bus. The data bus brings the broadcast data sample to each tap. The coefficient bus contains the weighting factor information. The sum-in bus brings the delayed output of the previous tap. Going out of each tap is the sum-out bus, which is the output of each tap and which goes to the sum-in input of the next tap. This regular, modular architecture lends itself to cascading of filter sections for larger filters.

Each tap has a coefficient register which contains the coefficient and control word information for that tap. This information is loaded in the initialization phase of the filter operation. Each tap has a shifter which uses the coefficient for the correct power of two weighting. The output of the shifter is the weighted data sample which is latched in a pipelining latch. The output of the latch is added to the output of the previous tap by an adder. The adder's output is delayed by one time unit and then passed on as the adder input of the next tap.

The filter works in two phases the initialization phase and the normal operation phase. In the initialization phase, the coefficients and control words are loaded for each tap. The coefficient registers are shift registers connected in a serial chain and the loading thereof is serial. A non-destructive verification of the loading is accomplished by reading out serially the coefficients and control words and reloading them back in a closed loop simultaneously so that at the end of the verification procedure all coefficients and control words reside in the correct registers.

This filter uses only powers of two as coefficients. As binary multiplication by powers of two is nothing but a shift of the multiplicand, complex multiplication is replaced by a simple shifter in this case. With the use of only negative powers of two as coefficients, the shift operation is simplified to only right shaft. Assuming the data (multiplicand) is always positive this shifter can handle both positive and negative coefficients.

For the example described and illustrated, the output of this multiplier is one's complement 16 bit data with the most significant bit as sign bit and fifteen magnitude bits, hence keeping the provision of maximum seven bit shift for the eight bit multiplicand, which is equivalent to a multiplication by $2^{-7}$. This is the most negative power of two which this multiplier can handle. Otherwise, properly programmed it can multiply the multiplicand with any one of the following values

$0, \pm2^0, \pm2^{-1}, \pm2^{-2}, ... \pm2^{-7}$.

However, this limitation can be overcome by an expansion of the coefficient space. The power-of-two coefficient space can easily be extended beyond the current limit of $\pm2^{-7}$ by modifying the shifter and certain other elements which handle its output. The overall architecture of the shifter does not change; it is only extended to include the increase of coefficient space.

Similarly, the architecture is not limited to data words of 8 bits. To increase this to any arbitrary size all that is needed is an increase the size of the NAND gate sets in the shifter from 8 to whatever the desired data size is. Obviously, the ADDER size will have to be increased or decreased according to the maximum value of both the coefficient space and data word size.

The proposed FIR filter structure is fully programmable for a coefficient space C such that :

$$[C \in \{ 0, \pm2^0, \pm2^{-1}, \pm2^{-2}, ..., \pm2^{-7} \}].$$

To maintain programmability of the filter, all possible shifts of the data inputs are provided for, using a multiplexer whose input is the output of sets of NAND gates, having positive inputs and a selection line. Outputs of the NAND gates are shifted and hard-wired to the multiplexer. The one's complement conversion of the multiplexer output is accomplished by a set of EXOR gates. Thus, using a shifter and a decoder, NAND gates and EXOR gates, the filter multiplies a coefficient by a data word without a standard multiplier.

The filter has been successfully simulated using various coefficients and random data.

Brief Description of the Drawings

Figure 1 is a block diagram of the classic realization of an FIR filter;
Figure 2 is a circuit diagram of the filter of the present invention;
Figure 3 is a circuit diagram of each tap of the filter of Figure 2;
Figure 4 is a diagram of the coefficient word for the filter of Figure 2;
Figure 4b shows the shifts of the multiplicand for positive coefficients of the filter of Figure 2;
Figure 5 is a logic diagram of the multiplier/shifter of the filter of Figure 2;
Figure 6 is a circuit diagram of the adder of the filter of Figure 2;
Figure 7 is a diagram showing the sequence of coefficient loading and verification for the filter of Figure 2.

Description of the Preferred Embodiment

Filtering is one of the most important functions of real time linear signal processing. Among the different types of digital filters there has been a great deal of interest in finite impulse response (FIR) digital filters (also called transversal filter). The reason for this is that powerful and mature optimization theories exist to aid in the filter design. FIR filters can easily be designed to approximate a prescribed magnitude/frequency response to arbitrary accuracy with an exactly linear phase characteristic. The non-recursive FIR filters contain only zeroes in the finite z-plane and hence are always stable. These features make them very attractive for most digital signal processing applications.

The FIR filter is characterized by the input/output relation.

$$Y_n = \sum_{i=0}^{N-1} C_i X_{n-i} \qquad (1)$$

where $X_{n-i} = X(t_n - iT_S)$ is the sampled input signal and $Y = Y(t_n)$ is the corresponding output signal. $T_S$ is the sampling period, $t_n = nT_S$ are sample instances and $f_S = 1/T_S$ is the sample rate. So each output sample is the weighted sum of a finite number of input samples (N in Equation 1).

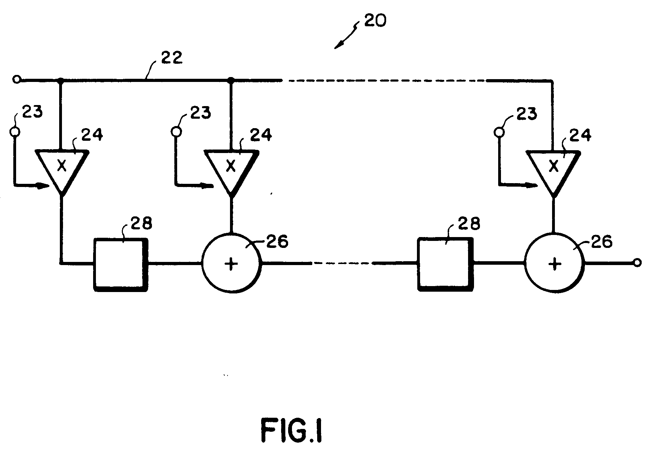

Figure 1 shows the well known semi-systolic parallel in, serial out transversal filter architecture 20. In such a structure the data is broadcast via a data bus 22 globally to the every tap in the filter, where it is multiplied in multiplier 24 by a weighting factor(the coefficient) from a coefficient register (not shown) appearing on input 23 and added in adder 26 to a delayed output from delay 28 of the previous tap. So the basic building blocks of any transversal filter 20 are the multiplier 24, the adder 26 and the delay 28. It is this weighting factor multiplier that is eliminated in the architecture of the invention.

In this classical realization of Equation 1, illustrated in Figure 1, the weighting of the input samples is accomplished by multipliers. The multiplier is the most time consuming and expensive building block of the filter, thus there has been a great effort to make multiplication operation cheaper and faster, to increase the overall speed of operation of the filter.

If the coefficient space is limited to only powers of two, then the complex multiplication is replaced by a simple shift operation. This is the main feature of the FIR filter structure presented in this application. It is obvious that this restriction on the coefficient space effects the performance of the filter. Substantial research has been conducted in compensating for this limitation. The most promising approach was outlined in the cross-referenced application by Koo and Miron, which discloses an implementation of the primary algorithm used by this structure. However, since this invention is a fully programmable filter, any power of two filter algorithm can be implemented.

Filter Architecture.

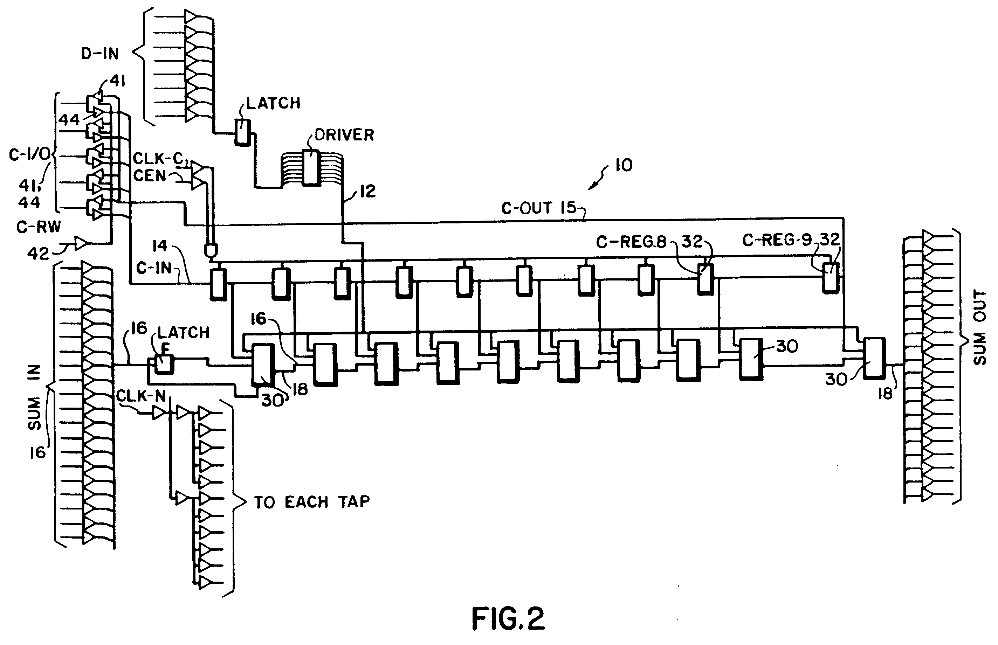

Referring to Figure 2, we will describe the architecture of filter 10 of this invention hierarchically. For the example described and illustrated, we use a ten tap filter, a data word of eight bits, a coefficient space from 0 to $\pm 2^{-7}$ and a final output bus 20 bits wide. Figure 2, the top level of the hierarchy, shows a ten tap structure of filter 10. Three busses go into each tap 30, the data bus 12, the coefficient bus 14, 15 and the sum-in bus 16. Going out of each tap is the sum-out bus 18. The purpose and function of each bus will be explained in the discussion of the filter operation, but it is clear that the structure is extremely regular and modular. This is an extremely important feature in the architecture from the VLSI implementation point of view.

Referring to Figure 2, the data bus 12 is the bus which brings the broadcast data sample D-IN to each tap 30. The coefficient bus is a loop originating at C-I/O gates 41 and includes the C-IN bus 14 and C-OUT bus 15. Bus 14 brings the weighting factor information and the sum-in bus 16 brings the delayed output of the previous tap 30. The sum-out bus 18 is the output of the tap 30 and can be fed into the sum-in input 16 bus of the next tap 30. Note that this architecture lends itself to cascading very naturally and easily, and is by no means limited to ten taps only.

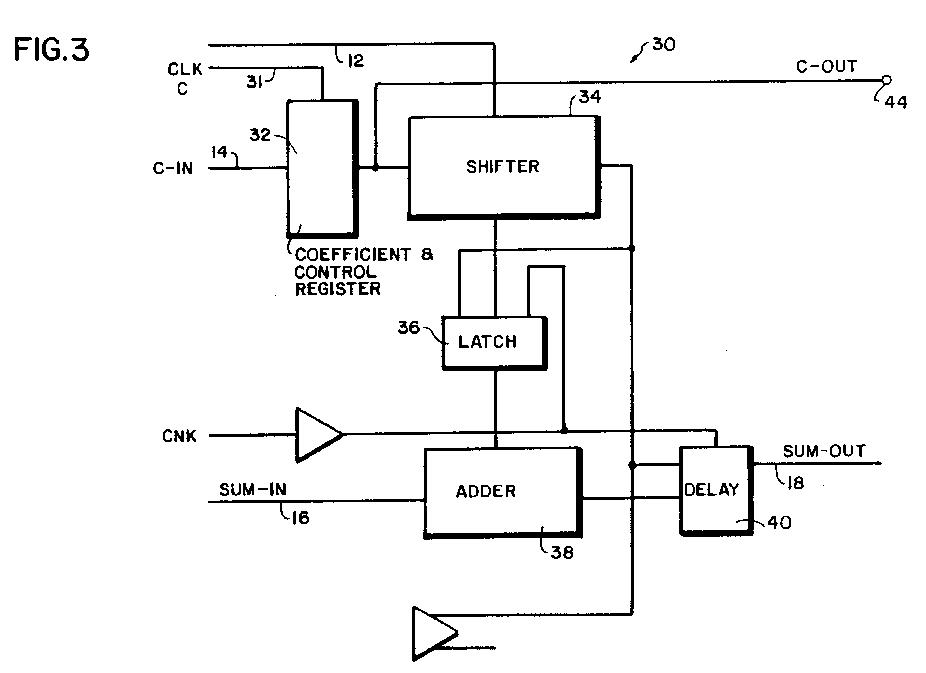

Figure 3 shows the building blocks of each tap 30. They will each be explained in detail later, for now we will just identify them. The C-REG 32 is the register containing the coefficient and control word information CCW. This information is loaded via the coefficient bus 14 in the initialization phase of the filter

4

EP 0 266 004 B1

operation. Most of this information is used by the SHIFTER 34 for the correct power of two weighting of data from data bus 12. The output of the SHIFTER 34 is the weighted data sample, which is latched in a pipelining latch 36, used for speed enhancement purposes. The output of the latch 36 is added to the output of the previous tap by the ADDER 38, and the ADDER's output is finally delayed in DELAY 40 by one time unit ofCLK-N before passed on <u>via</u> SUMOUT bus 18 and SUM-IN bus 16 as the ADDER input of the next tap.

In the following section we will explain the coefficient/control word loading and non-destructive verification procedure, during the initialization phase of the filter operation.

<u>Coefficient loading and verification</u>

Filter 10 works in two phases: the initialization phase and the normal operation phase. The coefficients and control words (CCW) are loaded during the first phase. The coefficient and control registers (C-REG) 32 are connected to each other in a serial chain, hence the loading is serial. Consider the particular case of a ten tap filter. CCW#9 is applied to the coefficient input bus (C-IN) 14 of Figure 2 and Figure 3 and all the C-REG's 32 are clocked by the clock CLK-C 31 (discussed later). It is obvious that CCW#9 will be loaded in C-REG#0. Now CCW#8 is applied to the C-IN bus 14 and all the C-REGs are clocked again. This time CCW#9 shifts from C-REG#0 to C-REG#1 and CCW#8 loaded in C-REG#0. This procedure is repeated ten times. Each time a new CCW is applied to the C-IN bus 14 and all the C-REG's 32 are clocked. That particular CCW, the most recent, is loaded in C-REG#0 and all the other CCW's are shifted to the next C-REG 32 in the serial chain. At the end of the cycle (ten clock pulses in this case), all the CCW are loaded in the correct order in the C-REGs 32. Summarizing, the CCW furthest away from the C-IN bus 14 is loaded first; the next furthest away is next, and so on till all the CCW's have been loaded. Each new CCW pushes all the old CCW's one register over, and at the end of the cycle the loading is complete.

The next step is verification of the above loading. The purpose is to make sure all the CCW's have been loaded in their required destination registers. We utilize a non-destructive verification procedure by which the CCW's are read out for verification and reloaded in a closed loop to the C-REG's 32 simultaneously, so at the end of the verification cycle the CCW's reside back at their respective C-REG's. To keep circuit simplicity and the I/O pins of the chip within limits, we choose not to use any CCW address schemes. Our verification procedure is also a serial procedure. In Figure 2 the C-I/O bus is a bidirectional bus, C-IN 14 and C-OUT 15, the direction of which is controlled by an external signal labeled C-RW42. When the C-RW 42 is set to 1, coefficient bus 14 acts as an input bus, and for C-RW set to 0, as an output bus 15. It is obvious that for the CCW loading procedure, C-RW is set to 1 and the CCW's are loaded as discussed above. For verification, the C-RW signal is set to 0 and the CLK-C 31 is clocked. At the first clock signal, the last coefficient (coefficient # 9) appears on C-OUT at the output gates 44 (Figure 3) and at the same time is loaded back from gates 41 in C-REG # 0. The next clock cycle brings the next to last coefficient on the C-OUT bus 15 and simultaneously loads it into C-REG#0 while pushing the current resident of C-REG # 0 (coefficient # 9) to C-REG # 1. At the end of the verification cycle (ten clock pulses) all the coefficients have been read out from the C-OUT bus 15 through gates 44 and at the same time reloaded in the C-REGs 32 <u>via</u> C-IN bus 14.

<u>Power of 2 Multiplier And Adder.</u>

Filter 10 uses only powers of two as coefficients. As binary multiplication by power of two is a shift of the multiplicand, complex multiplication is replaced by a simple shifter 34 in this case. With the use of only negative powers of two as coefficients, the shift operation is simplified to only right shift. Assuming the data (multiplicand) has eight bits and is always positive, and with the assumptions stated supra, this multiplier can handle both positive and negative coefficients. Output of this shifter 34 is one's complement 16 bit data with the most significant bit (MSB) as sign bit and fifteen magnitude bits, hence keeping the provision of maximum seven bit shift for the eight bit multiplicand, (an assumption of the example), which is equivalent to a multiplication by $2^{-7}$. This is the most negative power of two which this multiplier can handle and which the filter requires as well. Otherwise, properly programmed, it can multiply the multiplicand with any one of the following values

$0, \pm 2^0, \pm 2^{-1}, \pm 2^{-2}, ...., \pm 2^{-7}$.

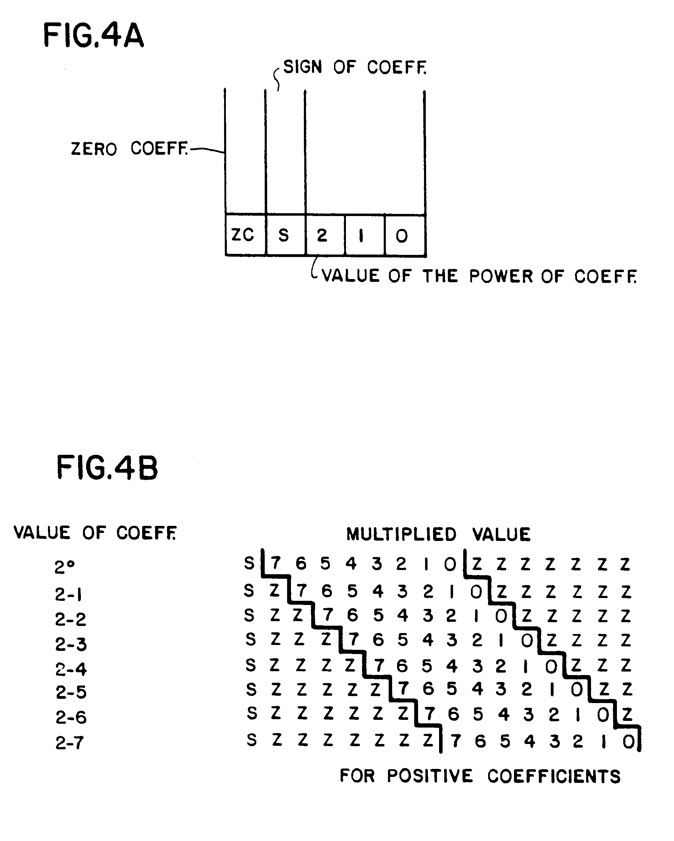

Figure 4a shows the format of a control word (CCW) and Figure 4b shows how the shift operation takes place for all positive values of coefficients. These are discussed infra.

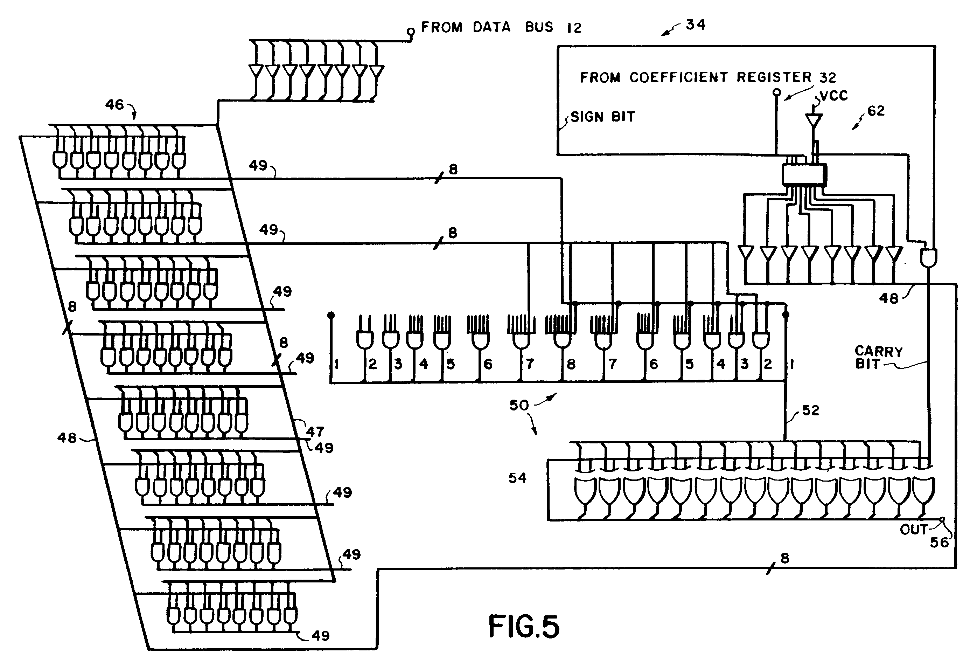

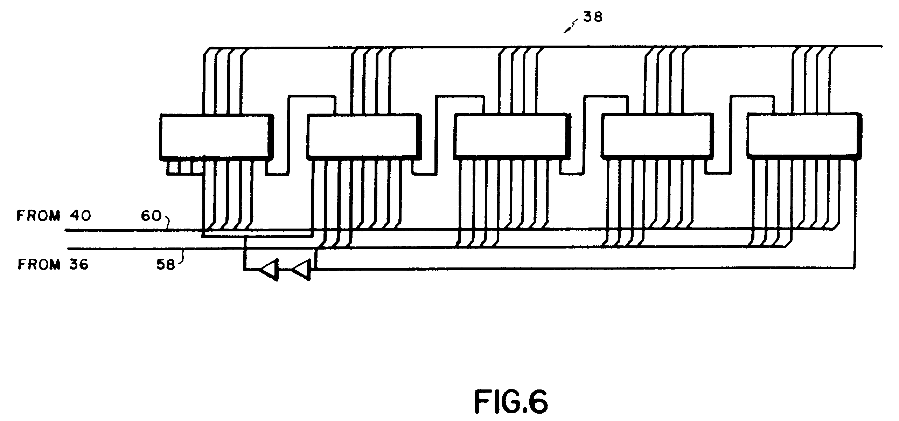

Figure 5 shows the logic diagram which implements the operation of the above-mentioned one's complement multiplier/shifter 34. To maintain programmability, we have incorporated in every stage of this

5

EP 0 266 004 B1

multiplier/shifter 34 all possible above-shown shifts and that is done by a simple multiplexing design for multiplier/shifter 34, whose input section 46 consists of eight sets of eight NAND gates. Each of the sets are fed on input lines 47 by the eight magnitude bits of the positive (thus not requiring any sign bit) multiplicand from data bus 12, as shown in the left side of Figure 5. Each set of NAND gates has a separate selection line 48 from decoder 62, discussed infra. One set of the eight sets of NAND gates 46 will be selected, depending upon the value of the coefficient programmed for that stage in a C-REG 32. Outputs 49 of the selected set of NAND gates 46 are properly shifted and hardwired to the output stage 50 of the shifter/multiplexer 34 to produce a fifteen bit magnitude bus 52 as shown in Figure 5. To avoid clutter in the drawing the output lines of only the first two sets of NAND gates 46 are shown connected. The final stage of this circuit 34 is the one's complement conversion logic 54, which is a set of EXOR gates which produces the bit by bit complement of bus 52, in case of negative coefficients, on output bus 56. As the multiplicand is always positive, the sign of the multiplied output on bus 56 depends on that of the coefficient. This sixteen (fifteen bit magnitude together with sign bit) bit bus 56 is latched in latch 36 (Figure 3) and delivered to the adder 38 (Figures 3, 6).

The section following the multiplier/shifter 34 and latch 36 is an adder 38 (Figure 6) of conventional design. It is a partially (4 bit) full carry look ahead adder cascaded to form a twenty bit adder. It receives the sixteen bit output of multiplier/shifter 34 <u>via</u> pipelining latch 36 as one of its inputs 58, and the other input 60 is the twenty bit output from delay latch 40 of the previous stage. The sign-extension technique is used for the smaller number in the adder. The sign of the smaller number which is in its one's complement form is also fed to the carry input of the adder, thereby converting the smaller number to its two's complement form. The following explanation determines the selection of the size (20 bits) of the larger number. At a particular stage or tap this number is the accumulated result of multiplier/shifter outputs of all the stages up to that stage. Thelarger the number of stages, the larger the accumulated result becomes. In the design of the chip, beside programmability, we incorporated its cascadibility as well. Experience shows that a maximum of sixteen taps for a filter with only power of two coefficients is a good choice to cover most of the video applications. Considering this fact the size (20 bits) is such that it will produce no overflow in the accumulated result of all sixteen stages after cascadation, even if each multiplier/shifter produces the largest possible output 7F80 (that takes place for largest possible eight bit multiplicand FF and the largest possible coefficient 1). To achieve this we need one sign bit, fifteen magnitude bits for each multiplied output and $\log_2 2^4$ bits for the sixteen ($2^4$) stage accumulation of them, which is 20 bits in total.

<u>Programming the Filter.</u>

As mentioned earlier, the FIR filter structure 10 is fully programmable for a coefficient space C such that :

$$[C \in \{0, \pm2^0, \pm2^{-1}, \pm2^{-2}, ...,\pm2^{-7}\}],$$

under the assumptions of the example described and illustrated. The coefficient and control word CCW contains the information of the actual shift, as well as the sign of the coefficient. It also contains information for a coefficient of magnitude 0 (zero). The CCW is afive bit word, the three least significant bits, (LSB) defining the power of the coefficient, the next bit controlling the sign and the most significant bit (MSB) for a zero coefficient. This is shown in Figure 4a. The three coefficient power control bits pass through a three-to-eight decoder 62 (Figure 5) and select one shift from $2^0$ to $2^{-7}$. The sign control bit determines the sign of the coefficient. In case of a zero coefficient (which is a special case since it is not a power of 2) the bit number is set to 1.

The entire programming operation is elaborated in the example of Table 1. In Table 1 the desired coefficient and its corresponding CCW code is shown. It is obvious that the use of the decoder 62 enables us to reduce the number of I/O pins required for the CCW.

<u>Possible Extension of the Coefficient Space.</u>

The power-of-two coefficient space can easily be extended beyond the current example limit of $\pm2^{-7}$ by modifying the shifter 34. For example, to increase the space to $\pm2^{-15}$ requires one more bit for the coefficient value (from 3 to 4) and a 4-to-16 decoder. It also requires sixteen sets of eight NAND gates (instead of the currently used eight sets). Thus, the overall architecture of the shifter 34 does not change; it is only extended to include the increase of coefficient space.

6

Similarly, filter 10 is not limited to a data word of eight bits. To increase this to any arbitrary size requires only an increase in the number of NAND gates per set from eight to whatever the data size desired is. Obviously, the size of ADDER 38 (number of bits) will have to be increased or decreased according to the maximum value of both the coefficient space and data word size.

VLSI Implementation and Simulation.

This filter 10 was implemented using Signetics Corporation's 2 micron double metal standard cell technology. The current chip has ten taps. The IC lay out was performed using Silver Lisco's CAL-MP software. We will now present the simulation results of the various modes of operation of the chip.

Initialization Phase.

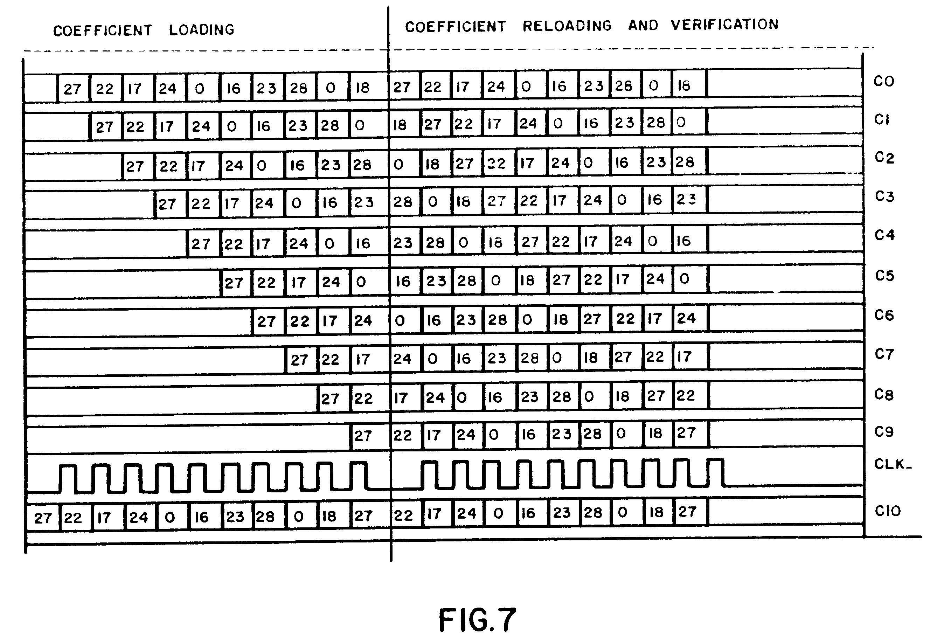

Referring to the coefficient loading procedure of Figure 7 and Table 2, we desire our filter coefficients to be as listed in Table 1. In Figure 7, we have used the decimal equivalents of Table 1 for clarity. We presented the coefficients to the C-IN bus 14 through the C-I/O gates 41 in reverse fashion and at the end of ten clock pulses we can see that they are in the correct C-REG's 32. As mentioned earlier, for loading coefficients the C-RW 42 signal is set to 1.

Now for the verification of our loading the C-RW 42 signal is set to 0 and we again apply ten coefficient clock pulses. The coefficient verification and reloading portion of Figure 7 and Table 2 show that all of the coefficients appeared at the C-I/O gates 44 via C-OUT bus 15 (in reverse order) and are reloaded into the C-REG's 32 via C-IN bus 14. This concludes the simulation of our initialization procedure.

Normal Operation.

For normal operation, the coefficient clock CLK-C enable signal (CEN) is set to 1. Since, once initialization of the filter has been successfully accomplished, we do not want the coefficients to change, this signal is an added protection against a stray coefficient clock pulse (CLK-C) altering the coefficients. Data is presented via the D-IN bus 12 and the normal operation clock (CLK-N) now becomes the only system clock and filtering is performed on the data.

We have successfully simulated the filter using various coefficients and random data.

## TABLE I

| COEFFICIENT CONTROL WORD | BINARY VALUE | DECIMAL VALUE | DESIRED COEFFICIENT |
|---|---|---|---|
| C0 | 10010 | 18 | $2^{-2}$ |
| C1 | 00000 | 0 | 0 |
| C2 | 11100 | 28 | $-2^{-4}$ |
| C3 | 10111 | 23 | $2^{-7}$ |
| C4 | 10000 | 16 | $2^{0}$ |
| C5 | 00000 | 0 | 0 |
| C6 | 11000 | 24 | $-2^{0}$ |
| C7 | 10001 | 17 | $2^{-1}$ |
| C8 | 10110 | 22 | $2^{-6}$ |
| C9 | 11011 | 27 | $-2^{-3}$ |

## TABLE II  COEFFICIENT LOADING PROCEDURE.

| TIME | C0 | C1 | C2 | C3 | C4 | C5 | C6 | C7 | C8 | C9 |
|---|---|---|---|---|---|---|---|---|---|---|
| 0.0 | X | X | X | X | X | X | X | X | X | X |
| 100.0 | X | X | X | X | X | X | X | X | X | X |
| 200.0 | 27 | X | X | X | X | X | X | X | X | X |
| 300.0 | 22 | 27 | X | X | X | X | X | X | X | X |
| 400.0 | 17 | 22 | 27 | X | X | X | X | X | X | X |
| 500.0 | 24 | 17 | 22 | 27 | X | X | X | X | X | X |
| 600.0 | 0 | 24 | 17 | 22 | 27 | X | X | X | X | X |
| 700.0 | 16 | 0 | 24 | 17 | 22 | 27 | X | X | X | X |
| 800.0 | 23 | 16 | 0 | 24 | 17 | 22 | 27 | X | X | X |
| 900.0 | 28 | 23 | 16 | 0 | 24 | 17 | 22 | 27 | X | X |
| 1000.0 | 0 | 28 | 23 | 16 | 0 | 24 | 17 | 22 | 27 | X |
| 1100.0 | 18 | 0 | 28 | 23 | 16 | 0 | 24 | 17 | 22 | 27 |

EP 0 266 004 B1

**TABLE II     COEFFICIENT VERIFICATION AND RELOADING PROCEDURE.**

| TIME | C0 | C1 | C2 | C3 | C4 | C5 | C6 | C7 | C8 | C9 |
|---|---|---|---|---|---|---|---|---|---|---|
| 3300.0 | 18 | 0 | 28 | 23 | 16 | 0 | 24 | 17 | 22 | 27 |
| 3350.0 | 27 | 18 | 0 | 28 | 23 | 16 | 0 | 24 | 17 | 22 |
| 3450.0 | 22 | 27 | 18 | 0 | 28 | 23 | 16 | 0 | 24 | 17 |
| 3550.0 | 17 | 22 | 27 | 18 | 0 | 28 | 23 | 16 | 0 | 24 |
| 3650.0 | 24 | 17 | 22 | 27 | 18 | 0 | 28 | 23 | 16 | 0 |
| 3750.0 | 0 | 24 | 17 | 22 | 27 | 18 | 0 | 28 | 23 | 16 |
| 3850.0 | 16 | 0 | 24 | 17 | 22 | 27 | 18 | 0 | 28 | 23 |
| 3950.0 | 23 | 16 | 0 | 24 | 17 | 22 | 27 | 18 | 0 | 28 |
| 4050.0 | 28 | 23 | 16 | 0 | 24 | 17 | 22 | 27 | 18 | 0 |
| 4150.0 | 0 | 28 | 23 | 16 | 0 | 24 | 17 | 22 | 27 | 18 |
| 4250.0 | 18 | 0 | 28 | 23 | 16 | 0 | 24 | 17 | 22 | 27 |

## Claims

1. A non-recursive finite impulse response (FIR) digital filter of n taps, where $1 \leq n$, comprising :

   means to receive and store a plurality of coefficients, one coefficient per tap, wherein each coefficient is an integer power of 2;

   means to receive and shift a data input word in each of said taps, the extent of said shift being determined by the value of said coefficient stored in said tap;

   said shifted data word being equivalent to the product of said input data word and said coefficient of said tap;

   means to add said product to the delayed output of the previous tap to form the cumulative sum of the products of all previous taps;

   means to delay and forward said cumulative sum to the next tap, and

   means to output the cumulative sum of all taps in said filter.

2. The filter of Claim 1 wherein said means to receive and store a plurality of coefficients comprises:
   input means to load said coefficients into said filter in an initialization phase;
   a coefficient bus to transport each of said coefficients to its destination tap; and
   a coefficient register at each tap to store the coefficient for said tap.

3. The filter of Claim 2 wherein:
   said coefficient bus is a serial bus;
   said coefficient registers are connected to each other in a serial chain; and
   said coefficients are loaded such that the last coefficient in the chain is loaded first and each coefficient is shifted down said chain in inverse relationship to tis proximity to the start of said chain.

4. The filter of Claim 3 wherein:
   said coefficient bus is a bidirectional bus;
   means to reverse the direction of serial bit flow on said coefficient bus;
   output terminal means on said coefficient bus; and
   means to verify the loading of said coefficients by reading them out serially to said output terminal means when said bus direction is reversed and reloading said coefficients in said destination taps.

5. The filter of Claim 1 wherein said means to receive and shift said data input word comprises:
   a data bus connected to each of said taps, whereby said data input words are broadcast to each of said taps;
   a shifter in each of said taps in the form of a NAND-NAND multiplexer connected to said data bus and to said coefficient register of said tap which receives each data word sequentially and shifts its bits according to said coefficient stored in said coefficient register, the output of said shifter being a weighted data sample.

6. The filter of Claim 5 wherein said coefficients are only negative powers of two and said shifter shifts right only.

7. The filter of Claim 1 where the coefficient space of said filter is limited to 0 to $\pm 2^{-7}$.

8. The filter of Claim 1 wherein said filter is fully programmable.

9. The filter of Claim 8 wherein said fully programmable filter includes means to handle all possible shifts of said data input word for given range ($0$ to $\pm 2^{-7}$).

10. The filter of Claim 1 wherein said filter is limited to sixteen taps without any overflow.

11. The filter of Claim 7 further including: means to expand the length of said filter by cascading stages of said filter.

12. The filter of Claim 1 wherein said means to add said products comprises:
   a sum-in bus which transports the cumulative sum of previous weighted data sample to each tap;
   an adder to add the output of said shifter of each tap to said cumulative sum;
   a delay element;
   a sum-out bus which transports the sum of said adder to said delay element, said delay element connected to the sum-in bus of the next tap.

13. The filter of Claim 12 wherein for an eight bit data word and a coefficient of $\pm 2^{-7}$ the output of said shifter is one sign bit and 15 magnitude bits in one's complement.

14. The filter of Claim 12 wherein said shifter for an eight bit data word comprises:
   a shifter having an input section comprising eight first sets of NAND gates, each set receiving all eight bits of said data word;
   a selection line from said coefficient register to each of said first sets of NAND gates, said coefficient determining which selection line is active;
   a second set of NAND gates to receive the output of the selected first set of NAND gates, the combination of the two sets of NAND gates providing the required shift as a shifter;

10

a set of EXOR gates at the output of said shifter to perform one's complement conversion on the output of said shifter, which output is latched for transfer to said adder.

15. The filter of Claim 3 wherein said coefficient register stores a coefficient control word having five bits, three for said coefficient, one bit for its sign and one bit for a zero coefficient.

16. The filter of Claim 3 further including a decoder to decode the output of said coefficient register.

**Patentansprüche**

1. Nicht-rekursives FIR-Filter mit n Abgriffen, wobei $1 \leq n$ ist mit:
   Mitteln zum Empfangen und Speichern einer Anzahl Koeffizienten, einen Koeffizienten je Abgriff, wobei jeder Koeffizient eine ganze Potenz von 2 ist;
   Mitteln zum Empfangen und Verschieben eines Dateneingangswortes in jedem der genannten Abgriffe, wobei die Größe dieser Verschiebung durch den Wert des in dem genannten Abgriff gespeicherten Koeffizienten bestimmt wird;
   wobei dieses verschobene Datenwort dem Produkt aus dem genannten Eingangsdatenwort und dem genannten Koeffizienten des genannten Abgriffes entspricht;
   Mitteln zum Addieren des genannten Produkten zu dem verzögerten Ausgang des vorhergehenden Abgriffes zum Bilden der kumulativen Summe aus den Produkten aller vorhergehenden Abgriffe;
   Mitteln zum Verzögern und Vorschieben der genannten kumulativen Summe zu dem nächsten Abgriff, und
   Mitteln zum Herausgeben der kumulativen Summe aller Abgriffe in dem genannten Filter.

2. Filter nach Anspruch 1, wobei die genannten Mittel zum Empfangen und Speichern einer Anzahl Koeffizienten die folgenden Elemente aufweisen:
   Eingangsmittel zum Eingeben der genannten Koeffizienten in das genannte Filter während einer Initialisierungsphase;
   einen Koeffizientenbus zum Befördern jedes der genannten Koeffizienten zu dem Bestimmungsabgriff; und
   ein Koeffizientenregister an jedem Abgriff zum Speichern des Koeffizienten für den genannten Abgriff.

3. Filter nach Anspruch 2, wobei:
   der genannte Koeffizientenbus ein serieller Bus ist;
   die genannten Koeffizientenregister mit jedem anderen in einer seriellen Kette verbunden sind; und
   die genannten Koeffizienten derart eingegeben werden, daß der letzte Koeffizient in der Kette als erster eingegeben wird und jeder Koeffizient in umgekehrter Beziehung zu seinem Abstand vom Anfang der genannten Kette an dieser Kette entlang nach unten geschoben wird.

4. Filter nach Anspruch 3, wobei:
   der genannte Koeffizientenbus ein bidirektionaler Bus ist;
   Mittel zum Umkehren der Richtung des seriellen Bitflusses in dem genannten Koeffizientenbus;
   Mittel zum Bestätigen der Eingabe der genannten Koeffizienten dadurch, daß sie seriell zu den genannten Ausgangsanschlußmitteln ausgelesen werden, wenn die genannte Busrichtung umgekehrt wird und der Neueingabe der genannten Koeffizienten in die genannten Bestimmungsabgriffe.

5. Filter nach Anspruch 1, wobei die genannten Mittel zum Empfangen und Verschieben des genannten Dateneingangswortes die nachfolgenden Elemente aufweisen:
   einen mit jedem der genannten Abgriffe verbundenen Datenbus, wobei die genannten Dateneingangsworte jedem der genannten Abgriffe zugesendet werden;
   einen Schieber in jedem der genannten Abgriffe in Form eines NAND-NAND-Multiplexers, der mit dem genannten Datenbus und dem genannten Koeffizientenregister des genannten Abgriffs verbunden ist, der jedes Datenwort sequentiell empfängt und dessen Bits entsprechend dem genannten in dem genannten Koeffizientenregister gespeicherten Koeffizienten verschiebt, wobei die Ausgangsgröße des genannten Schiebers einen gewichteten Datenabtastwert ist.

**6.** Filter nach Anspruch 5, wobei die genannten Koeffizienten nur negative Zweierpotenzen sind und der genannte Schieber nur nach rechts schiebt.

**7.** Filter nach Anspruch 1, wobei der Koeffizientenraum des genannten Filters auf 0 bis $\pm 2^{-7}$ beschränkt ist.

**8.** Filter nach Anspruch 1, wobei dieses Filter völlig programmierbar ist.

**9.** Filter nach Anspruch 8, wobei dieses völlig programmierbare Filter Mittel aufweist zum Durchführen aller möglichen Verschiebungen des genannten Dateneingangswortes für einen bestimmten Bereich (0 bis $\pm 2^{-7}$).

**10.** Filter nach Anspruch 1, wobei dieses Filter ohne irgendeinen Überlauf auf sechzehn Abgriffe begrenzt ist.

**11.** Filter nach Anspruch 7, das weiterhin die nachfolgenden Elemente aufweist:
Mittel zum Ausbauen der länge des genannten Filters durch Kaskadenschaltung der Stufen des genannten Filters.

**12.** Filter nach Anspruch 1, wobei die genannten Mittel zum Addieren der genannten Produkte die nachfolgenden Elemente aufweisen:
einen Summen-Eingabe-Bus, der die kumulative Summe vorhergehender gewichteter Datenabtastwerte zu jedem Abgriff befördert,
einen Addierer zum Addieren des Ausgangswertes des genannten Schiebers jedes Abgriffs zu der genannten kumulativen Summe;
ein Verzögerungsglied;
einen Summen-Ausgabe-Bus, der die Summe vom genannten Addierer zu dem genannten Verzögerungsglied befördert, wobei das genannte Verzögerungsglied mit dem Summen-Eingabe-Bus des nächsten Abgriffs verbunden ist.

**13.** Filter nach Anspruch 12, wobei für ein acht-Bit-Datenwort und einen Koeffizienten von $\pm 2^{-7}$ der Ausgangswert des genannten Schiebers ein Vorzeichen-Bit und 15 Größen-Bits in dem Komplement desselben ist.

**14.** Filter nach Anspruch 12, wobei der genannte Schieber für ein acht-Bit-Datenwort die nachfolgenden Elemente aufweist:
einen Schieber mit einem Eingabeteil mit acht ersten NAND-Gatter-Sätzen, wobei jeder Satz alle acht Bits des genannten Datenwortes erhält;
eine Selektionsleitung von dem genannten Koefzzientenregister zu jedem der genannten ersten NAND-Gattersätze, wobei der genannte Koeffizient bestimmt, welche Selektionsleitung aktiv ist;
einen zweiten NAND-Gattersatz zum Empfangen des Ausgangswertes des selektierten ersten NAND-Gattersatzes, wobei die Kombination der beiden NAND-Gattersätze die erforderliche Verschiebung eines Schiebers ergibt;
einen EXOR-Gattersatz am Ausgang des genannten Schiebers zum Durchführen dessen Komplementumsetzung am Ausgang des genannten Schiebers, wobei dieser Ausgang aufgefangen wird zur Beförderung zu dem genannten Addierer.

**15.** Filter nach Anspruch 3, wobei das genannte Koeffizientenregister ein Koeffizientensteuerwort mit fünf Bits speichert, von denen drei Bits für den genannten Koeffizienten, ein Bit für dessen Vorzeichen und ein Bit für einen Null-Koeffizienten.

**16.** Filter nach Anspruch 3, weiterhin mit einem Decoder zum Decodieren des Ausgangs des genannten Koeffizientenregisters.

**Revendications**

**1.** Filtre numérique à réponse impulsionnelle finie (FIR) non récursif de n prises, où $1 \leqq n$, comprenant :
un moyen pour recevoir et stocker une pluralité de coefficients, un coefficient par prise, dans lequel chaque coefficient est une puissance entière de 2;

un moyen pour recevoir et décaler un mot d'entrée de données dans chacune des prises, l'étendue du décalage étant déterminée par la valeur du coefficient stocké dans la prise;

le mot de données décalé étant équivalent au produit du mot de données d'entrée et du coefficient de la prise;

un moyen pour ajouter le produit à la sortie retardée de la prise précédente pour former la somme cumulative des produits de toutes les prises précédentes;

un moyen pour retarder et acheminer la somme cumulative vers la prise suivante, et

un moyen pour sortir la somme cumulative de toutes les prises dans le filtre.

2. Filtre suivant la revendication 1, dans lequel le moyen destiné à recevoir et à stocker une pluralité de coefficients comprend :

un moyen d'entrée pour charger les coefficients dans le filtre dans une phase d'initialisation,

un bus de coefficients pour transporter chacun des coefficients vers sa prise de destination, et

un registre de coefficient à chaque prise pour stocker le coefficient pour la prise.

3. Filtre suivant la revendication 2, dans lequel :

le bus de coefficients est un bus série;

les registres de coefficients sont connectés l'un à l'autre en une chaîne en série, et

les coefficients sont chargés de telle sorte que le dernier coefficient de la chaîne soit chargé en premier lieu et que chaque coefficient soit décale vers le bas de la chaîne en relation inverse de sa proximité du départ de la chaîne.

4. Filtre suivant la revendication 3, dans lequel :

le bus de coefficients est un bus bidirectionnel;

un moyen pour inverser la direction d'écoulement des bits en série sur le bus de coefficients;

des bornes de sortie sur le bus de coefficients, et

un moyen pour vérifier le chargement des coefficients en les extrayant en série vers les bornes de sortie lorsque la direction du bus est inversée et en rechargeant les coefficients dans les prises de destination.

5. Filtre suivant la revendication 1, dans lequel le moyen destiné à recevoir et à décaler le mot d'entrée de données comprend :

un bus de données connecté à chacune des prises, de sorte que les mots d'entrée de données sont diffusés vers chacune des prises;

un dispositif de décalage dans chacune des prises sous la forme d'un multiplexeur NON-ET-NON-ET connecté au bus de données et au registre de coefficient de la prise qui reçoit chaque mot de données séquentiellement et décale ces bits en fonction du coefficient stocké dans le registre de coefficient, la sortie du dispositif de décalage étant un échantillon de données pondéré.

6. Filtre suivant la revendication 5, dans lequel les coefficients sont exclusivement des puissances négatives de deux et le dispositif de décalage décale vers la droite uniquement.

7. Filtre suivant la revendication 1, dans lequel l'espace de coefficient du filtre est limité à 0 à $\pm 2^{-7}$.

8. Filtre suivant la revendication 1, dans lequel le filtre est entièrement programmable.

9. Filtre suivant la revendication 8, dans lequel le filtre entièrement programmable comprend un moyen permettant de traiter tous les décalages possibles du mot d'entrée de données pour une gamme donnée (0 à $\pm 2^{7}$).

10. Filtre suivant la revendication 1, dans lequel le filtre est limité à 16 prises sans dépassement de capacité.

11. Filtre suivant la revendication 7, comprenant en outre :

un moyen pour étendre la longueur du filtre en disposant des étages du filtre en cascade.

13

**12.** Filtre suivant la revendication 1, dans lequel de moyen pour additionner les produits comprend :

un bus d'entrée de somme qui transporte la somme cumulative

d'échantillons de données pondérées précédents vers chaque prise;

un additionneur pour ajouter la sortie du dispositif de décalage de chaque prise à la somme cumulative;

un élément à retard;

un bus de sortie de somme qui transporte la somme de l'additionneur à l'élément à retard, l'élément à retard étant connecté au bus d'entrée de somme de la prise suivante.

**13.** Filtre suivant la revendication 12, dans lequel, pour un mot de données de huit bits et un coefficient de $\pm 2^{-7}$, la sortie du dispositif de décalage est un bit de signe et quinze bits de grandeur en complément à un.

**14.** Filtre suivant la revendication 12, dans lequel le dispositif de décalage pour un mot de données de huit bits comprend :

un dispositif de décalage comportant une section d'entrée comprenant huit premiers jeux de circuit-portes NON-ET, chaque jeu recevant les huit bits du mot de données;

une ligne de sélection allant du registre de coefficient à chacun des premiers jeux de circuits-portes NON-ET, le coefficient déterminant la ligne de sélection qui est active;

un second jeu de circuits-portes NON-ET destiné à recevoir la sortie du premier jeu sélectionné de circuits-portes NON-ET, la combinaison de deux jeux de circuits-portes NON-ET assurant le décalage requis comme un dispositif de décalage;

un jeu de circuits-portes OU exclusif à la sortie du dispositif de décalage pour exécuter une conversion complémentée à un sur la sortie du dispositif de décalage, cette sortie étant verrouillée pour un transfert vers l'additionneur.

**15.** Filtre suivant la revendication 3, dans lequel le registre de coefficient stocke un mot de commande de coefficient comportant cinq bits, trois pour le coefficient, un pour son signe et un pour un coefficient zéro.

**16.** Filtre suivant la revendication 3, comprenant, en outre, un décodeur pour décoder la sortie du registre de coefficient.

FIG.I

FIG.2

FIG.3

EP 0 266 004 B1

# FIG.4A

ZERO COEFF.

SIGN OF COEFF.

| ZC | S | 2 | 1 | 0 |

VALUE OF THE POWER OF COEFF.

# FIG.4B

VALUE OF COEFF.                    MULTIPLIED VALUE

| $2^0$ | S | 7 | 6 | 5 | 4 | 3 | 2 | 1 | 0 | Z | Z | Z | Z | Z | Z |
| $2^{-1}$ | S | Z | 7 | 6 | 5 | 4 | 3 | 2 | 1 | 0 | Z | Z | Z | Z | Z |
| $2^{-2}$ | S | Z | Z | 7 | 6 | 5 | 4 | 3 | 2 | 1 | 0 | Z | Z | Z | Z |
| $2^{-3}$ | S | Z | Z | Z | 7 | 6 | 5 | 4 | 3 | 2 | 1 | 0 | Z | Z | Z |
| $2^{-4}$ | S | Z | Z | Z | Z | 7 | 6 | 5 | 4 | 3 | 2 | 1 | 0 | Z | Z |
| $2^{-5}$ | S | Z | Z | Z | Z | Z | 7 | 6 | 5 | 4 | 3 | 2 | 1 | 0 | Z |
| $2^{-6}$ | S | Z | Z | Z | Z | Z | Z | 7 | 6 | 5 | 4 | 3 | 2 | 1 | 0 |
| $2^{-7}$ | S | Z | Z | Z | Z | Z | Z | Z | 7 | 6 | 5 | 4 | 3 | 2 | 1 | 0 |

FOR POSITIVE COEFFICIENTS

FROM DATA BUS 12

34

FROM COEFFICIENT REGISTER 32

SIGN BIT

VCC

62

46

49

49

8

8

48

47

49

48

49

49

49

49

49

49

1 2 3 4 5 6 7 8 7 6 5 4 3 2 1

50

CARRY BIT

52

54

OUT

56

8

FIG.5

EP 0 266 004 B1

FIG.6

EP 0 266 004 B1

| | COEFFICIENT LOADING | | | | | | | | | | COEFFICIENT RELOADING AND VERIFICATION | | | | | | | | | | | |
|---|---|---|---|---|---|---|---|---|---|---|---|---|---|---|---|---|---|---|---|---|---|---|---|
| | 27 | 22 | 17 | 24 | 0 | 16 | 23 | 28 | 0 | 18 | 27 | 22 | 17 | 24 | 0 | 16 | 23 | 28 | 0 | 18 | | CO |
| | | 27 | 22 | 17 | 24 | 0 | 16 | 23 | 28 | 0 | 18 | 27 | 22 | 17 | 24 | 0 | 16 | 23 | 28 | 0 | | C1 |
| | | | 27 | 22 | 17 | 24 | 0 | 16 | 23 | 28 | 0 | 18 | 27 | 22 | 17 | 24 | 0 | 16 | 23 | 28 | | C2 |
| | | | | 27 | 22 | 17 | 24 | 0 | 16 | 23 | 28 | 0 | 18 | 27 | 22 | 17 | 24 | 0 | 16 | 23 | | C3 |
| | | | | | 27 | 22 | 17 | 24 | 0 | 16 | 23 | 28 | 0 | 18 | 27 | 22 | 17 | 24 | 0 | 16 | | C4 |
| | | | | | | 27 | 22 | 17 | 24 | 0 | 16 | 23 | 28 | 0 | 18 | 27 | 22 | 17 | 24 | 0 | | C5 |
| | | | | | | | 27 | 22 | 17 | 24 | 0 | 16 | 23 | 28 | 0 | 18 | 27 | 22 | 17 | 24 | | C6 |
| | | | | | | | | 27 | 22 | 17 | 24 | 0 | 16 | 23 | 28 | 0 | 18 | 27 | 22 | 17 | | C7 |
| | | | | | | | | | 27 | 22 | 17 | 24 | 0 | 16 | 23 | 28 | 0 | 18 | 27 | 22 | | C8 |
| | | | | | | | | | | 27 | 22 | 17 | 24 | 0 | 16 | 23 | 28 | 0 | 18 | 27 | | C9 |
| | | | | | | | | | | | | | | | | | | | | | | CLK_ |
| 27 | 22 | 17 | 24 | 0 | 16 | 23 | 28 | 0 | 18 | 27 | 22 | 17 | 24 | 0 | 16 | 23 | 28 | 0 | 18 | 27 | | C10 |

# FIG.7